# EUROPÄISCHE PATENTSCHRIFT

(11) **EP 3 345 008 B1**
(45) Veröffentlichungstag und Bekanntmachung des Hinweises auf die Patenterteilung: **10.04.2024**
(21) Anmeldenummer: 16753361.1
(22) Anmeldetag: 17.08.2016
(51) Int. Cl.: G01R 29/08, F03D 17/00, F03D 80/30, G01R 15/18, G01R 19/00

(54) **VERFAHREN ZUR ERFASSUNG VON BLITZSTROMPARAMETERN AN ANLAGEN MIT EINER ODER MEHREREN FANGEINRICHTUNGEN UND BLITZSTROMABLEITPFADEN**
METHOD FOR SENSING LIGHTNING-CURRENT PARAMETERS AT INSTALLATIONS HAVING ONE OR MORE CAPTURING DEVICES AND LIGHTNING-CURRENT DIVERSION PATHS
DISPOSITIF DE DÉTECTION DE PARAMÈTRES DE COURANT DE FOUDRE SUR DES INSTALLATIONS MUNIES D'UN OU DE PLUSIEURS PARAFOUDRES ET DE TRAJETS DE DÉRIVATION DU COURANT DE FOUDRE

(30) Priorität: 04.09.2015 DE 102015011739; 28.01.2016 DE 102016000930
(43) Veröffentlichungstag der Anmeldung: 11.07.2018
(73) Patentinhaber: DEHN SE, 92318 Neumarkt i.d. OPf. (DE)
(72) Erfinder: BIRKL, Josef, 92334 Berching (DE); EICHLER, Bernhard, 94149 Koesslarn (DE); BÖHM, Thomas, 92366 Hohenfels (DE); SCHORK, Franz, 90461 Nürnberg (DE)
(74) Vertreter: Prinz & Partner mbB
(86) Internationale Anmeldenummer: PCT/EP2016/069465
(87) Internationale Veröffentlichungsnummer: WO 2017/036793

(56) Entgegenhaltungen:
- EP-A1- 2 395 320
- EP-B1- 1 631 846
- WO-A1-2009/083006
- WO-A1-2014/157110
- DE-A1-102013 002 927
- US-A1- 2007 108 770
- US-A1- 2013 028 739
- A. ASAKAWA ET AL: "Direct Lightning Hits on Wind Turbines in Winter Season Lightning Observation Results for Wind Turbines at Nikaho Wind Park in Winter", IEEJ TRANSACTIONS ON ELECTRICAL AND ELECTRONIC ENGINEERING, Bd. 5, Nr. 1, 1. Januar 2010 (2010-01-01), Seiten 14-20, XP055025133, ISSN: 1931-4973, DOI: 10.1002/tee.20487

## Beschreibung

Die Erfindung betrifft ein Verfahren zur Erfassung von Blitzstromparametern an Windenergieanlagen mit einer oder mehreren Fangeinrichtungen und Blitzstromableitpfaden mittels Einsatz mehrerer Sensoren an den Blitzstromableitpfaden zur Bestimmung eines Blitzstromereignisses sowie mit anschließender Bewertung des Blitzstromereignisses und dessen Auswirkung auf die jeweilige Windenergieanlage gemäß Patentanspruch 1.

Trifft ein Blitzschlag ein Gebäude oder eine technische Anlage, bringt dies hohe Blitzströme zum Fließen. Blitzströme sind sogenannte eingeprägte Ströme. Daher stellt ein Blitzstrom eine primäre Bedrohung dar, nach der sich sämtliche Schutzmaßnahmen gemäß Blitzschutznorm DIN EN 62305 richten.

Blitzschutzkomponenten, durch die der volle Blitzstrom oder Blitzteilströme entsprechend der Stromaufteilung in einer Gesamtanlage fließen, müssen den thermischen und mechanischen Wirkungen des Blitzstroms standhalten. Es ist bekannt, Blitzstrommesseinheiten zu verwenden, um Blitzeinschläge und damit Blitzströme zu erfassen. Derartige Messeinheiten dienen auch der Ermittlung der Blitzstromparameter des Gesamtblitzstroms oder der Blitzteilströme, um selbige zu analysieren, so dass die Belastung bestimmter Anlagenteile ermittelt werden kann. Aus den jeweils bestimmten Daten können dann konkrete Wartungsarbeiten an den Anlagen abgeleitet werden.

Aus der US 2014/0093373 A1 ist ein Verfahren zur Bestimmung von Blitzeinschlägen an Windkraftanlagen vorbekannt, wobei dort im gemeinsamen Erdleiter ein Stromsensor befindlich ist, welcher ermittelt, ob und inwieweit die Rezeptoren in den Rotorflügeln einer Blitzstrombeeinflussung ausgesetzt waren.

Die EP 2 385 246 A1 zeigt eine weitere Einrichtung zur Bestimmung von Blitzeinschlägen bei Windkraftanlagen, wobei im Bereich der Turbine der Windkraftanlage ein Ozonsensor vorgesehen ist. Im Fall eines Blitzeinschlags entsteht eine Funkenentladung, welche wiederum einen bestimmten Betrag von Ozon freisetzt, der dann detektierbar ist.

Gemäß der EP 1 631 846 B1 ist es bekannt, einen Blitzstrom eines Rotorblatts vollständig oder teilweise durch mindestens einen elektrischen Widerstand zu leiten und die Erwärmung des Widerstands zu bestimmen, um hieraus eine qualitative Strombewertung zu ermöglichen.

Eine Anordnung einer Vielzahl von Sensoren an Rotorblättern mit nachgeschalteter Datenanalyse und Auswertung ist in der EP 2 270 524 A1 oder in der US 2012/0133146 A1 beschrieben.

Gemäß der Lehre nach US 2012/0133143 A1 ist es bekannt, in jedem Rotorflügel einer Windkraftanlage Sensoren anzuordnen, mit dem Ziel der Auswertung von möglichen Schäden nebst örtlicher Lokalisierung des jeweiligen Schadens im Rotorblatt. Ergänzend ist dort eine Rogowski-Spule im Bereich des Sockels der Windkraftanlage vorhanden, um eine Gesamtbelastung bei Blitzeinschlägen zu bestimmen.

Die gattungsbildende EP 1 754 887 A1 offenbart verteilt über ein Rotorblatt einer Windkraftanlage angeordnete Feldsensoren, um Blitzeinschläge zu registrieren. Die Daten dieser Sensoren werden in einer Bewertungseinheit zusammengeführt. Darüber hinaus ist eine zentrale Stelle vorhanden, die der Blitzstrombestimmung dient.

Ein weiteres System zur Detektion eines Blitzeinschlags ist aus der WO 2009/083006 A1 bekannt, welche ein Windrad mit einer Detektionsvorrichtung offenbart. Die Detektionsvorrichtung umfasst eine Ladungsmessvorrichtung zum Ermitteln einer in einem Blitzstromableitpfad induzierten Ladung und eine Abschätzeinheit zum Abschätzen der durch den Blitzstrom verursachten Abnutzung der Komponenten des Windrands.

Aus der US 2013/028739 A1 ist ein Windrad bekannt, dessen Rotorblätter jeweils über eine Mehrzahl von Rezeptoren sowie über Blitzstromsensoren und verfügen, die als Rogowski-Spulen ausgebildet sind. Die beiden Rogowski-Spulen sind für unterschiedliche Maximalstromwerte ausgelegt.

Allen vorgenannten Lösungen ist gemeinsam, dass selbige in der Lage sind, ein Blitzstromereignis als solches festzustellen. Dabei geht es bei der vorbekannten Erfassung von Blitzstromereignissen um die Ermittlung von Stoßströmen, d.h. von Kurzzeitimpulsen hoher Energie.

Normativ ist festgelegt, dass Blitzfangeinrichtungen insbesondere bei Windkraftanlagen auf der Oberfläche des Rotorblatts anzubringen sind, wo Blitzkanalverbindungen entstehen und ohne Fangeinrichtung Blitzeinschläge oder -durchschläge verursacht werden können. Dabei ist herstellerseitig sicherzustellen, dass die Fangeinrichtungen in den entsprechenden Halterungen fixiert sind. Fangeinrichtungen sind so zu planen, dass sie dem erwarteten Verschleiß durch Wind, Feuchtigkeit und Teilchen standhalten. Durch Abtragung an Fußpunkten des Lichtbogens verschleißen Fangeinrichtungen im Verlauf der Zeit. Damit ist die Abtragung abhängig von der Häufigkeit und der Stärke von Blitzstromereignissen, so dass zum Zweck einer optimierten Wartung eine Ermittlung der Häufigkeit von Blitzstromereignissen sinnvoll ist.

Eine Abtragung ist jedoch auch abhängig von der Ladung, die im Fall von blitzstrombedingten Lichtbögen auftritt. Daher ist es normativ vorgesehen, dass die jeweiligen Hersteller Verfahren für eine regelmäßige Inspektion der Fangeinrichtungen festlegen, so dass der geschätzte Auslegungswert der Lebensdauer und die Wartungs- und Austauschintervalle festgesetzt und nachgeprüft werden können.

Es hat sich hier gezeigt, dass für die Lebensdauer entsprechender Anlagen und Einrichtungen nicht allein die Kurzentladungsparameter bei Blitzstromereignissen relevant sind, sondern vielmehr auch zu bestimmen ist, ob und inwieweit Langzeitströme mit einer Dauer von mehr als 2 ms im Fall eines Blitzstroms auftreten.

Langzeitströme mit hohen Ladungswerten können bei Fangeinrichtungen am Fußpunkt des Lichtbogens des Blitzes zu einer starken Erwärmung bis hin zu Ausschmelzungen führen. Besonders bei Windenergieanlagen können derartige Erscheinungen zu großen Problemen, wie z.B. Ausschmelzungen an Rezeptoren der Windflügel führen.

Aus dem Vorgenannten ist es daher Aufgabe der Erfindung, ein weiterentwickeltes Verfahren zur Erfassung von Blitzstromparametern an Anlagen mit mehreren Fangeinrichtungen und Blitzstromableitpfaden, insbesondere Windenergieanlagen, anzugeben, welches in der Lage ist, eine verbesserte und exaktere Aussage bezüglich des Zustands der Anlage und hinsichtlich von Wartungsintervallen zu liefern.

Die Lösung der Aufgabe der Erfindung erfolgt gemäß der Lehre nach Patentanspruch 1, wobei die Unteransprüche mindestens zweckmäßige Ausgestaltungen und Weiterbildungen umfassen.

Erfindungsgemäß wird neben einem Erfassen von Kurzzeitimpulsen und Strompeakwerten auch eine Ermittlung der Ladung bedingt durch Langzeitströme nebst Bestimmung der diesbezüglich spezifischen Energie über die komplette Langzeitstromflussdauer vorgenommen, so dass Schäden durch hohe Ladungswerte sicher abschätzbar sind. Es werden also durch die erfindungsgemäßen Maßnahmen Ladungswerte und W/R von Kurzzeit- und Langzeitkomponenten eines Blitzschlags ermittelt. Damit ist es möglich, auswertungsseitig auch denjenigen Fall zu berücksichtigen, bei welchem nur ein Langzeitstrom mit niedrigen überlagerten Impulsen auftritt, was in bekannten Messeinrichtungen nicht registrierbar ist.

Die erfindungsgemäße Lehre ermöglicht es darüber hinaus, Langzeitströme ohne überlagerte Impulsströme zu erfassen und zu bewerten. Derartige Langzeitströme repräsentieren etwa 50% der Blitzentladungen an Anlagen mit großer Betriebshöhe.

Die Erfassung von Langzeitströmen ist insbesondere an hohen Bauwerken bzw. exponierten Gebäuden oder Anlagen von großer Bedeutung, wie dies insbesondere bei Windenergieanlagen der Fall ist. Mit der Umsetzung des erfindungsgemäßen Verfahrens ist eine Lösung geschaffen, die allen normativen Anforderungen in Sachen Betrieb und Blitzschutz bei Windenergieanlagen genügt.

Bei dem Verfahren zur Erfassung von Blitzstromparametern an Windenergieanlagen mit mehreren Fangeinrichtungen und Blitzstromableitpfaden, wird erfindungsgemäß an jeder der Fangeinrichtungen oder an jedem Blitzstromableitpfad ein Blitzstromerfassungssensor angeordnet, welcher bezogen auf die jeweilige Fangeinrichtung oder den jeweiligen Blitzstromableitpfad ausschließlich eine Ja/Nein-Aussage bezüglich eines Blitzstromereignisses liefert. Diese Blitzstromerfassungssensoren können sehr einfach ausgestaltet sein. Selbige dienen nur der Detektion, an welcher Fangeinrichtung bzw. in welchem Blitzstromableitpfad ein Einschlag tatsächlich erfolgte. Die Blitzstromerfassungssensoren sind erfindungsgemäß so ausgebildet, dass sie ohne zusätzliche Messleitung Daten an eine zentrale Auswerteeinheit liefern, und zwar insbesondere melden, dass im betroffenen Ableitpfad ein Blitzstrom geflossen ist.

An einer zentralen Stelle der Zusammenführung der Blitzstromableitpfade in Richtung Erde ist mindestens ein Blitzstrommesssensor vorgesehen, welcher sowohl Stoßströme mit einer Dauer unter 5 ms als auch Langzeitströme mit einer Dauer von mehr als 5 ms detektiert, wobei weiterhin die Höhe der Ladung des jeweiligen aufgetretenen Langzeitstroms bestimmt und zur Ermittlung möglicher Auswirkungen auf die Anlage herangezogen wird.

Demnach ist es nur notwendig, an der zentralen Stelle der Zusammenführung der Blitzstromableitpfade einen hochwertigen Blitzstrommesssensor auszubilden, der in der Lage ist, mit hoher Genauigkeit die relevanten Blitzstromparameter zu bestimmen.

Durch das drahtlose Anbinden der Blitzstromerfassungssensoren an die zentrale Einheit entstehen keine ansonsten gegebenen Probleme bei leitungsgebundener Datenübermittlung insbesondere im Hinblick auf den notwendigen Trennungsabstand.

Da die Blitzstromerfassungssensoren nur die erwähnte Ja/Nein-Aussage hinsichtlich eines Blitzstroms liefern und weiterleiten müssen und im klassischen Sinne keine Messung erfolgt, können die Sensoren in einfacher Weise aufgebaut und kostengünstig realisiert werden. Darüber hinaus haben derartige Sensoren nur einen sehr geringen Energieverbrauch, so dass auf aufwendige externe Energieversorgungseinrichtungen verzichtet werden kann. Beispielsweise kann die notwendige Energie für den Blitzstromerfassungssensor aus dem elektromagnetischen Feld des eigentlichen Blitzstroms gewonnen werden. Ebenso besteht die Möglichkeit, bei Blitzstromerfassungssensoren, die in bewegten Blitzableitungen, z.B. Rotorblättern von Windkraftanlagen vorgesehen sind, die notwendige Energie aus der Bewegungsenergie der Rotorblättern, z.B. unter Nutzung von Piezoelementen zu gewinnen.

In Weiterbildung der Erfindung werden bei der Bestimmung möglicher Auswirkungen von Blitzströmen die ermittelten Blitzstromparameter dem jeweiligen Blitzstromableitpfad zugeordnet, wobei hierfür auf die räumliche Zuordnung der Blitzstromerfassungssensoren zu den entsprechenden Teilen der Anlage zurückgegriffen wird. Diesbezüglich übermittelt der entsprechende Blitzstromerfassungssensor bei Weiterleitung einer Ja-Aussage bezogen auf ein Blitzstromereignis auch eine Adresse, die die räumliche Zuordnung des betreffenden Blitzstromsensors angibt.

Die durch den Blitzstrom bedingten Ladungswerte werden zur Analyse der erwarteten Lebensdauer von mechanischen, stromdurchflossenen Komponenten der Anlage genutzt, wobei diesbezüglich auf eine tabellarische Zuordnung von Erfahrungswerten aus Langzeituntersuchungen zurückgegriffen werden kann.

Erfindungsgemäß weist der mindestens eine Blitzstrommesssensor zwei Rogowski-Spulen auf. Eine erste Rogowski-Spule erfasst Einzelimpulse großer Stromhöhe mit bis zu 200 kA und kurzer Impulsdauer bis zu 5 ms.

Eine zweite Rogowski-Spule dient der Langzeitstromerfassung niedrigerer Ströme bei einer Impulsdauer von bis zu 1 s.

Das erfindungsgemäße Verfahren ist zur Anwendung bei Windenergieanlagen vorgesehen, wobei die Blitzstromerfassungssensoren an der jeweiligen Verbindungsstelle zwischen dem jeweiligen Windkraftrotorblatt und der Nabe und der mindestens eine Blitzstromsensor an oder in der Nähe der Rotorwelle, bevorzugt im Bereich des Übergangs Nabe zu Gondel vorgesehen ist.

Bevorzugt erfolgt auch bei dieser erfindungsgemäßen Verwendung die Signalübertragung zur Ja/Nein-Entscheidung zwischen den Blitzstromerfassungssensoren und einer Auswerteeinheit drahtlos.

Die für die Arbeitsweise der Blitzstromerfassungssensoren erforderliche elektrische Betriebsenergie wird in erfindungsgemäßer Weiterbildung aus der Bewegungsenergie der Rotorblätter gewonnen.

Die Erfindung soll nachstehend anhand eines Ausführungsbeispiels der bevorzugten Anwendung bei Windenergieanlagen näher erläutert werden.

Aufgrund der höheren Anforderungen an Windenergieanlagen hinsichtlich der Leistung und der damit verbundenen Investitionssummen werden von Versicherungen und Windparkbetreibern Forderungen nach einem zuverlässigen Messsystem zur Bestimmung von Blitzströmen erhoben. Dies gilt nicht nur für neue Anlagen, sondern auch für die Nachrüstung bereits bestehender Windenergieanlagen.

In der Norm DIN EN 61400-24, Windenergieanlagen - Teil 24: Blitzschutz, ist u.a. geregelt, wie das Blitzschutzableitungssystem und dessen Verbindungsbauteile zu realisieren sind. Verbindungen zum Ableitungssystem müssen fest und dauerhaft sein und sicherstellen, dass das Gesamtsystem der kombinierten Einwirkung von elektrischen, thermischen und elektrodynamischen Einflüssen des Blitzstroms standhalten kann.

Es ist nachzuweisen, dass die Blitzschutzanlage in der Lage ist, der mechanischen Beanspruchung in den Rotorblättern standzuhalten. Alle Verbindungsbauteile müssen geprüft werden. Innenteile des Ableitungssystems und der Verbindungsbauteile sind so auszuführen, dass das Risiko innerer Entladungen, die von diesen Teilen ausgehen können, so gering wie möglich gehalten wird. Außen angebrachte Ableitungen sind als Fangeinrichtungen definiert. Die Hersteller derartiger Einrichtungen und Anlagen müssen ein Verfahren für eine regelmäßige Inspektion aller Teile des Ableitungssystems und von dessen Verbindungsbauteilen, die durch Umgebungsbedingungen abgenutzt werden, festlegen, so dass die Bedingungen und der geschätzte Auslegungswert der Lebensdauer und die Wartungsintervalle der entsprechenden Teile nachprüfbar sind.

Aufgrund der Höhe und der exponierten Lage der Rotorblätter von Windenergieanlagen ist die gesamte Rotorblattkonstruktion während ihrer Betriebslebensdauer häufig stark elektrischen Feldern ausgesetzt. Durch Gewitterwolken werden starke statische und transiente elektrische Felder erzeugt, welche auf die Rotorblattkonstruktion elektrisch einwirken, und im Verlauf der Zeit die Isolationseigenschaften von Verbundwerkstoffen verschlechtern.

Das erfindungsgemäße Verfahren in seiner bevorzugten Anwendung bei Windenergieanlagen dient der Erfassung aller relevanten Blitzstromparameter, und zwar sowohl von Kurzzeitimpulsen als auch Langzeitkomponenten und deren Ladungswerte, so dass eine sehr sichere Abschätzung von Schäden und ein sinnvolles Festlegen von Wartungsintervallen erfolgen kann.

Bei der Verwendung von drahtlosen Blitzstromerfassungssensoren ergibt sich der Vorteil gegenüber leitungsgebundenen Blitzstromsensoren, dass das Messsignal über rotierende Bauteile übertragen werden kann. Die zentrale Datenerfassung bezogen auf die von den Blitzstromerfassungssensoren gelieferten Ja/Nein-Werte erfolgt mittels einer Einheit, die zweckmäßigerweise in der Gondel der Windkraftanlage untergebracht ist. Die Nabe oder Welle, die über ein Getriebe auf den eigentlichen elektrodynamischen Generator führt, bildet die zentrale Stelle der Zusammenführung der Blitzstromableitpfade in Richtung Erdung. Dort wird ein Blitzstrommesssensor vorgesehen, der beispielsweise aus zwei speziell modifizierten Rogowski-Spulen besteht. Die Rogowski-Spulen sind so ausgestaltet, dass einerseits Einzelimpulse von der Stromhöhe erfasst werden und andererseits aber auch eine Langzeitstromerfassung niedrigerer Ströme bis hin zu einer Impulsdauer von 1 s realisierbar ist.

Die in der Auswerteeinheit der jeweiligen Windkraftanlage ermittelten und gesammelten Daten können auf Relevanz überprüft und bei der Erfassung abnormaler Störgrößen im Sinne einer Alarmfunktion dem Anlagenbetreiber übermittelt werden. Um auch bei Ausfall der gesamten Windenergieanlage hier noch eine Alarmdatenübertragung zu gewährleisten, kann auf eine notstromgestützte UMTS- oder GSM-Telekommunikationsverbindung zurückgegriffen werden.

## Patentansprüche

1. Verfahren zur Erfassung von Blitzstromparametern an Windenergieanlagen mit mehreren Fangeinrichtungen und Blitzstromableitpfaden mittels Einsatz mehrerer Sensoren an den Blitzstromableitpfaden zur Bestimmung eines Blitzstromereignisses sowie mit anschließender Bewertung des Blitzstromereignisses und dessen Auswirkung auf die jeweilige Windenergieanlage,
wobei an jeder der Fangeinrichtungen oder jedem Blitzstromableitpfad ein Blitzstromerfassungssensor ausgebildet ist, welcher bezogen auf die jeweilige Fangeinrichtung oder den jeweiligen Blitzstromableitpfad eine Ja/Nein-Aussage bezüglich eines Blitzstromereignisses liefert,
wobei an einer zentralen Stelle der Zusammenführung der Blitzstromableitpfade in Richtung Erdung mindestens ein Blitzstrommesssensor vorgesehen ist, wobei weiterhin die Höhe der Ladung des jeweiligen aufgetretenen Langzeitstroms bestimmt und zur Ermittlung möglicher Auswirkungen auf die Windenergieanlage herangezogen wird,
**dadurch gekennzeichnet, dass**
der mindestens eine Blitzstrommesssensor sowohl Stoßströme mit einer Dauer von unter 5 ms als auch Langzeitströme mit einer Dauer von mehr als 5 ms detektiert,
wobei der mindestens eine Blitzstrommesssensor zwei Rogowski-Spulen aufweist, wobei eine erste Rogowski-Spule Einzelimpulse großer Stromhöhe bis zu 200 kA mit kurzer Impulsdauer von bis zu 5 ms und eine zweite Rogowski-Spule Einzelimpulse niedrigerer Ströme bei einer Impulsdauer von bis zu 1 s erfasst, und
wobei die Blitzstromerfassungssensoren an der jeweiligen Verbindungsstelle zwischen Windkraftrotorblatt und Nabe und der mindestens eine Blitzstrommesssensor an der Rotorwelle vorgesehen ist.

2. Verfahren nach Anspruch 1, **dadurch gekennzeichnet, dass** bei der Bestimmung möglicher Auswirkungen von Blitzströmen die ermittelten Blitzstromparameter dem jeweiligen Blitzstromableitpfad zugeordnet werden und hierfür auf die räumliche Zuordnung der Blitzstromerfassungssensoren zu Teilen der Windenergieanlage zurückgegriffen wird.

3. Verfahren nach Anspruch 1 oder 2, **dadurch gekennzeichnet, dass** die ermittelten blitzstrombedingten Ladungswerte zur Analyse der erwarteten Lebensdauer von insbesondere mechanischen, stromdurchflossenen Komponenten der Windenergieanlage verwendet werden.

4. Verfahren nach einem der vorhergehenden Ansprüche, **dadurch gekennzeichnet, dass** die Signalübertragung zur Ja/Nein-Entscheidung zwischen den Blitzstromerfassungssensoren und einer Auswerteeinheit drahtlos erfolgt.

5. Verfahren nach Anspruch 4, **dadurch gekennzeichnet, dass** die für die Arbeitsweise der Blitzstromerfassungssensoren erforderliche elektrische Betriebsenergie aus der Bewegungsenergie der Rotorblätter gewonnen wird.

## Claims

1. A method of sensing lightning current parameters at wind power plants comprising a plurality of lightning arresters and lightning current diversion paths by using a plurality of sensors on the lightning current diversion paths to identify a lightning current event and comprising a subsequent evaluation of the lightning current event and the effect thereof on the particular wind power plant,
wherein a lightning current detection sensor is formed at each of the lightning arresters or each lightning current diversion path and provides a yes/no statement in respect of a lightning current event in relation to the respective lightning arrester or the respective lightning current diversion path,
wherein at least one lightning current measuring sensor is provided at a central point of the merging of the lightning current diversion paths toward the ground, wherein furthermore the level of the charge of the respective long-term current that has occurred is determined and made use of to identify possible effects on the wind power plant,
**characterized in that**
the at least one lightning current measuring sensor detects both surge currents having a duration of less than 5 ms and long-term currents having a duration of more than 5 ms,
wherein the at least one lightning current measuring sensor includes two Rogowski coils, wherein a first Rogowski coil detects single pulses of a high current level up to 200 kA with a short pulse duration of up to 5 ms, and a second Rogowski coil detects single pulses of lower currents at a pulse duration of up to 1 s, and
wherein the lightning current detection sensors are provided at the respective connection point between the wind turbine rotor blade and the hub, and the at least one lightning current measuring sensor is provided at the rotor shaft.

2. The method according to claim 1, **characterized in that** when possible effects of lightning currents are determined, the lightning current parameters identified are allocated to the respective lightning current diversion path and the spatial allocation of the lightning current detection sensors to parts of the wind power plant is resorted to for this purpose.

3. The method according to claim 1 or 2, **characterized in that** the lightning current-related charge values identified are used to analyze the expected service life of, in particular, mechanical current-carrying components of the wind power plant.

4. The method according to any of the preceding claims, **characterized in that** the signal transmission for the yes/no decision is effected wirelessly between the lightning current detection sensors and an evaluation unit.

5. The method according to claim 4, **characterized in that** the electrical operating energy required for the operation of the lightning current detection sensors is obtained from the kinetic energy of the rotor blades.

## Revendications

1. Procédé de détection de paramètres du courant de foudre dans les centrales éoliennes comprenant une pluralité de parafoudres et de chemins de dérivation du courant de foudre en utilisant une pluralité de capteurs sur les chemins de dérivation du courant de foudre pour déterminer un événement de courant de foudre, et comprenant une évaluation ultérieure de l'événement de courant de foudre et de son effet sur la centrale éolienne correspondante,
un capteur de détection du courant de foudre étant réalisé sur chacun des parafoudres ou sur chaque chemin de dérivation du courant de foudre, lequel fournit une information oui ou non concernant un événement de courant de foudre par rapport au parafoudre respectif ou au chemin de dérivation du courant de foudre respectif,
au moins un capteur de mesure du courant de foudre étant prévu à un point central de la fusion des chemins de dérivation du courant de foudre vers la terre, le niveau de charge du courant de longue durée respectif qui est survenu étant en outre déterminé et utilisé pour identifier les effets possibles sur la centrale éolienne,
**caractérisé en ce que**
ledit au moins un capteur de mesure du courant de foudre détecte tant les courants d'impulsion d'une durée inférieure à 5 ms que les courants de longue durée d'une durée supérieure à 5 ms,
ledit au moins un capteur de mesure du courant de foudre comprenant deux enroulements de Rogowski, un premier enroulement de Rogowski détectant des impulsions uniques d'un niveau de courant élevé allant jusqu'à 200 kA avec une courte durée d'impulsion allant jusqu'à 5 ms, et un deuxième enroulement de Rogowski détectant des impulsions uniques de courants plus faibles avec une durée d'impulsion allant jusqu'à 1 s, et
les capteurs de détection du courant de foudre étant agencés au point de raccordement respectif entre la pale du rotor de l'éolienne et le moyeu, et ledit au moins un capteur de mesure du courant de foudre étant prévu au niveau de l'arbre du rotor.

2. Procédé selon la revendication 1, **caractérisé en ce que** lors de la détermination des effets possibles des courants de foudre, les paramètres du courant de foudre identifiés sont attribués au chemin de dérivation du courant de foudre respectif et l'attribution spatiale des capteurs de détection du courant de foudre à des parties de la centrale éolienne est utilisée à cette fin.

3. Procédé selon la revendication 1 ou 2, **caractérisé en ce que** les valeurs de charge identifiées liées au courant de foudre sont utilisées pour analyser la durée de vie prévue des composants en particulier mécaniques parcourus par du courant de la centrale éolienne.

4. Procédé selon l'une des revendications précédentes, **caractérisé en ce que** la transmission du signal pour la décision oui ou non est effectuée sans fil entre les capteurs de détection du courant de foudre et une unité d'évaluation.

5. Procédé selon la revendication 4, **caractérisé en ce que** l'énergie de fonctionnement électrique nécessaire pour le mode opératoire des capteurs de détection du courant de foudre est obtenue à partir de l'énergie cinétique des pales du rotor.
